(19)

Europäisches
Patentamt
European
Patent Office
Office européen
des brevets

(11) **EP 2 523 008 B1**

(12) **EUROPEAN PATENT SPECIFICATION**

(45) Date of publication and mention
of the grant of the patent:
**22.07.2015 Bulletin 2015/30**

(51) Int Cl.:
*G01R 31/26* (2014.01)      *H05B 33/08* (2006.01)

(21) Application number: **11165352.3**

(22) Date of filing: **09.05.2011**

(54) **Method of characterising an LED device**

Verfahren zur Charakterisierung einer LED-Vorrichtung

Procédé de caractérisation d'un dispositif à DEL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.11.2012 Bulletin 2012/46**

(73) Proprietor: **NXP B.V.**
**5656 AG Eindhoven (NL)**

(72) Inventors:
• **Nguyen Hoang, Viet**
**Redhill, Surrey RH1 1DL (GB)**
• **Bancken, Pascal**
**Redhill, Surrey RH1 1DL (GB)**

(74) Representative: **Hardingham, Christopher Mark**
**NXP B.V.**
**Intellectual Property & Licensing**
**Red Central**
**60 High Street**
**Redhill, Surrey RH1 1SH (GB)**

(56) References cited:
**EP-A1- 1 711 038          EP-A1- 2 296 436
WO-A1-2004/057924     US-A1- 2004 233 144
US-A1- 2007 040 696    US-A1- 2007 205 793
US-A1- 2010 327 872    US-A1- 2011 084 701**

• **LIN YING-YAN ET AL: "An efficiency-enhanced
low dropout Linear HB LED driver for automotive
application", ELECTRON DEVICES AND SOLID-
STATE CIRCUITS, 2008. EDSSC 2008. IEEE
INTERNATIONAL CONFERENCE ON, IEEE,
PISCATAWAY, NJ, USA, 8 December 2008
(2008-12-08), pages 1-4, XP031411318, ISBN:
978-1-4244-2539-6**
• **FENG TIAN ET AL: "Research and realization of
innovative LED illumination system for DLP
projector", AUDIO, LANGUAGE AND IMAGE
PROCESSING, 2008. ICALIP 2008.
INTERNATIONAL CONFERENCE ON, IEEE,
PISCATAWAY, NJ, USA, 7 July 2008 (2008-07-07),
pages 194-199, XP031298343, ISBN:
978-1-4244-1723-0**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field

This invention relates to method of characterising a light emitting diode (LED) device. It further relates to LED drivers configured to operate such a method.

Background

Due to their known advantages, such as high efficiency in terms of lumens per watt, small form factor and durability, LEDs are used as light sources in high performance lighting fixtures. LEDs are increasing preferred light sources in difficult-to-replace lighting fixtures, such as street lights, traffic signal lights and in fixture that require high reliability, such as automotive lights, for instance for safety reasons.

Similar to many other light sources, the light output from an LED decays over time, ultimately leading to LED failure. In order to avoid complete failure, LEDs are typically replaced according to a fixed schedule. However, since the replacement schedules generally try to completely avoid pre-replacement failure, and there is a significant spread in the time at which an LED may be expected to fail, many LEDs are replaced considerable before a likely failure, which is clearly wasteful; alternatively, if the replacement schedule is extended in order to reduce such waste, some LEDs are likely to fail before being replaced, which is generally inconvenient and could be dangerous.

In order to predict, and thereby where appropriate prevent, the failure of LEDs, it is known to monitor or measure the light output by means of external optical sensors such as photodiodes. Whilst this method is generally robust, it requires additional components, circuitry and wiring, and is thus undesirable. Further, in non-ideal lighting environments, such as where there may be interference from other LEDs or extraneous light sources, the method may be inaccurate.

United States Patent Application Publication No. US2010/327872 discloses a life test device comprising an oven, current source, voltage meter, a control module and a process module. The process module calculates a junction temperature of the LED according to the forward voltage and a variation relationship formula between the forward voltage and the temperature of the oven; the calculated junction temperature may be used in predicting the lifetime of the LED.

The document US2007/0205793 teaches that a forward conduction resistance may be used to determine open/short abnormalities in a LED. The document US2007/0040696 teaches that various measurements may be made in order to monitor operational conditions and failure conditions of a LED.

There is thus an ongoing requirement to provide other methods of predicting the failure of LEDs, and characterising their performance in general.

Summary

According to a first aspect of the invention there is provided a method of characterising an LED device, the method comprising: determining a first value and a second value of a characteristic-resistance Ron, by determining a first and second voltage (Vh, Vl) across the LED device whilst a respective first and second current (ih, il) is passing through the device; determining the characteristic-resistance from the ratio of the difference between the first and second voltage, and the first and second current, according to Ron = (Vh - Vl) / (ih - il); and predicting an end of an operational lifetime of the device from the first value (Ron1) and second value (Ron2) of the characteristic-resistance.

Thus, according to this aspect, the change in the value of the characteristic-resistance may be considered as a proxy for, or may be indicative of, the deterioration to the output light intensity from the LED; knowledge of the deterioration to the output light intensity may be used to make predictions about the remaining life of the LED. In some cases, the prediction may be a straightforward extrapolation of the change in characteristic-resistance; however in more complex environments in which the operating conditions of the LED have altered or been modified over time, the prediction may be more involved, or may take into account changes in operating conditions.

In embodiments, the first value of the characteristic-resistance may be determined at the start of an operational lifetime of the LED device. In embodiments, the second value of the characteristic-resistance may be determined after a part of an operational lifetime of the LED device. In such embodiments, the first value of the characteristic-resistance may be determined after a further part of the operational lifetime of the LED device, and the method may further comprise extrapolating to estimate a value of the characteristic-resistance at a start of the operational lifetime of the LED device.

The method may further comprise determining at least one further value of the characteristic resistance after respectively at least one further part of the operation life, and predicting an end of an operational lifetime may comprise extrapolating an evolution or slope of the characteristic resistance against operational lifetime. This may involve a linear extrapolation, or a non-linear extrapolation particularly where the operating conditions have altered or been modified. In general, the more measurements of the characteristic resistance are made, the more accurate is likely to be the prediction of the end of life, since a better fit may be made to the data, and changes in operating conditions may more readily be taken into account.

In embodiments, the method further comprises storing at least a value of the characteristic resistance in a memory. Thus, for example, an initial value of the characteristic may be stored, or a series of values may be stored, in order to better monitor the evolution or change of the characteristic resistance. Alternatively or in addition and without limitation, one or more parameters which represent or are indicative of the evolution may be stored.

In embodiments, the end of an operation lifetime is predicted to be when the characteristic-resistance Ron differs from its value at the start of the operational lifetime, by a predetermined amount. Without limitation, the predetermined amount may be in the range 0.6 to 1.6 Ohms, more particularly may be in the range 0.8 to 1.2 Ohm, or may be approximately 1 ohm.

In embodiments, the first current is larger than the second current by between 4 and 6 orders of magnitude, or in particular by 5 orders of magnitude.

In embodiments, the method may further comprise providing a warning signal indicative of the predicted end of an operational lifetime.

In embodiments, the method further comprises selecting one of a plurality of performance bins based on the predicted end of lifetime. Thus the characterisation may involve a pre-screening of LEDs, and categorising them according to their expected lifetime, so that LEDs with similar lifetimes can be "binned" together, thereby simplifying for instance, replacement during preventative maintenance operations or similar since LEDs in the same performance bin may be expected to deteriorate in a broadly similar manner. This is analogous to other binning of LEDs to provide, for example, wavelength matching

According to another aspect there is provided an integrated circuit configured to drive an LED device and to operate the method of any preceding claim.

These and other aspects will be apparent from, and elucidated with reference to, the embodiments described hereinafter.

Brief description of Drawings

Embodiments of the invention will be described, by way of example only, with reference to the drawings, in which:

Figure 1 is a graph of typical forward bias current-voltage (IV) plots for an LED (light emitting diode);
Figure 2 plots the change in an effective resistance, at a particular operating condition, against operational lifetime of an LED, at a relatively high drive current at Figure 2(a), and at a relatively low drive current at figure 2(b);
Figure 3 shows the change in ∆Ron against normalised output light intensity - which is representative of an operational lifetime of a high-power blue LED;
Figure 4 is a table of experimental measurements showing the relationship between the relative optical output and lifetime;
Figure 5 shows the relationship between the relative light output and ∆Ron, for the devices listed in figure 4; and
Figure 6 shows a flow diagram of a method according to embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

Detailed description of embodiments

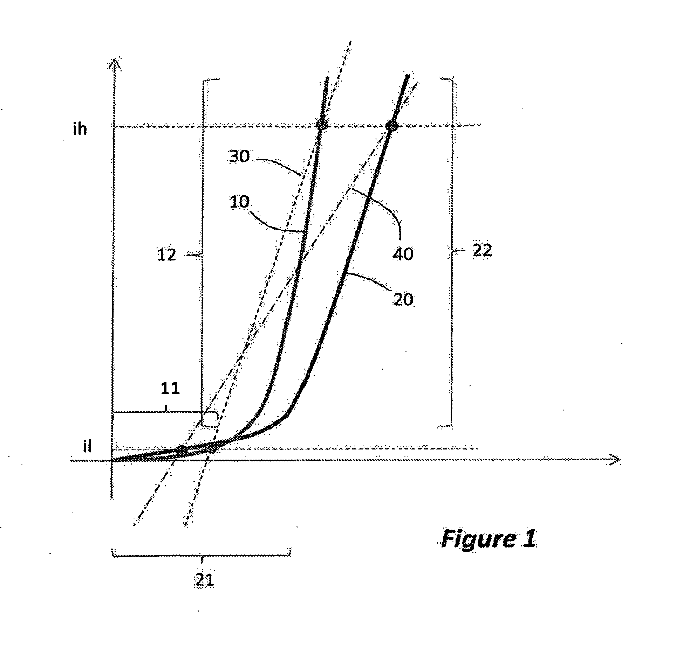

Figure 1 is a graph of typical forward bias current-voltage (IV) plots for an LED. Curve 10 is a typical curve for a "new" or pristine LED, that is to say, an LED which is at the start of its operational lifetime. The curve is characterised by having low leakage current. This is shown towards the left of the curve a region 11, below the 'knee' of the curve. Further, above the 'knee', the curve is generally steep as shown at region 12.

The figure further shows a corresponding IV-characteristic 20 of a typical aging LED. Relative to the new, or pristine, LED curve 10, this curve 20 has a somewhat higher leakage at low forward bias, shown at region 21, and typically a somewhat less steep slope at higher forward bias, as shown at 22.

The curve may be understood as follows: as the LED gets older, the metal -semiconductor contact of the LED may deteriorate, leading to extra resistance at those contacts. This increased contact resistance leads to an increased effective resistance at larger driving currents. At the same time, there are typically new leakage paths forming within the LED. This corresponds to increased non-radiative recombination of the carriers at the p-n junction; such non-radiative recombination generally increases over the operational lifetime of the LED due to changes in the crystallography of the semiconductor, together with electro-migration or thermal diffusion of impurities and dislocations. Consequently, the light output of the device decreases, and it consumes more power - which typically results in hotter operation, and even hotter temperature if the operating conditions are adjusted to maintain the same output luminosity.

Figure 1 also shows two current levels (horizontal lines) corresponding to 2 driving levels of the LED. A first driving level (ih) is well above the "knee" of the curve, so the diode is switched on and providing an optical output. The second driving level (il) is significantly lower, but importantly is non-zero and positive. Since this driving level is below the knee of the curve, the LED is effectively, that is, optically, switched off (that is to say, the radiative recombination is negligibly low or zero).

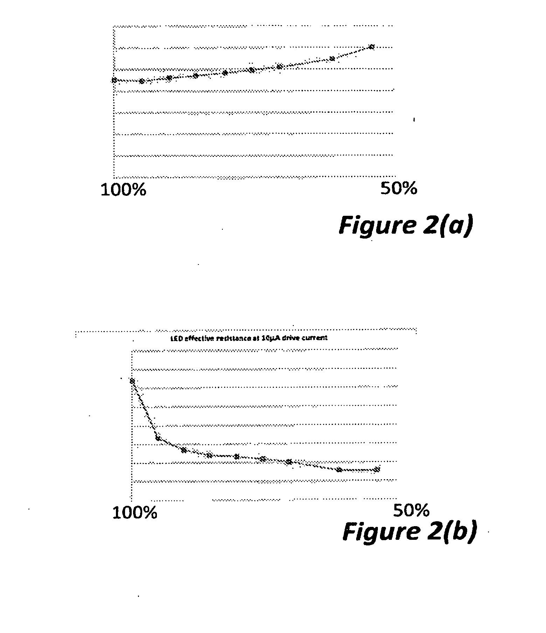

As shown in the figure, the operating voltage of the LED at the higher driving level ih is higher for the aged device, whilst the operating voltage of the LED at the low driving level il is lower for the aged device. This has been measured experimentally, as shown in Figure 2, in which is plotted the change in an effective resistance, at a particular operating condition, against operational lifetime of an LED. By "effective resistance" is meant, at particular operating conditions (in this case, fixed current), a value of the ratio of voltage to current. Since the LED has a non-linear current-voltage response, Ohms law does not apply, so the measurement is not a true resistance, but none-the-less yields a useful value, in other words figure of merit, which is termed herein "effective resistance".

Figure 2(a) shows the change over operational lifetime of the effective resistance, determined according to vl / il, of an LED with a high drive current (in this case 1A). The normalised light output over time is plotted on the x-axis (or abscissa); this is taken as being representative of the aging of the device. The effective resistance is plotted on the y-axis (or ordinate). The effective resistance is seen to increase with operation of the device. As discussed above, this may be explained in terms of increased series resistance. With reference to figure 1, this is equivalent to the operating point at a high drive current ih moving to the right as the device ages.

Figure 2(b) shows the change over operational lifetime of an effective resistance, determined according to vl / il, of an LED with a low drive current (in this case $10\mu A$). The axes are the same as in Figure 2(a) - although in this case, the vertical scale is from 18-22 kOhms, in contrast to the 0-7 Ohms shown in figure 2(a). In both cases the normalised output is plotted from 100% (ie a new or pristine LED) on the left, to 50%, for a heavily aged device, on the right. The effective resistance is seen to decrease with operation of the device. As discussed above, this may be explained in terms of increased leakage paths. With reference to figure 1, this is equivalent to the operating point at a low drive current il moving to the left, as the device ages.

A characteristic value of a parameter, which has dimensions of Ohms, and thus may be termed a characteristic-resistance, may be derived from the above measurements. Herein this characteristic-resistance will also be described as an "on-resistance" Ron for the device, where Ron is calculated according to

$$Ron \ = (Vh - Vl) \ / (ih - il).$$

It will immediately be appreciated, that Ron is a function of the currents chosen, that is to say Ron - Ron(il, ih). Furthermore, it will be apparent that Ron is equal to the inverse of the slope of the line joining the operating points at high and low drive currents, shown at 30 for the pristine device and at 40 for the aged device.

As shown in figure 1 and explained above in terms of the loss mechanisms, the slope of the line joining the operating points at high and low drive current becomes shallower as the device ages. Thus its inverse increases. This increase may be denoted $\Delta$Ron and is generally positive. $\Delta$ Ron is a function of the devices life, and the value of $\Delta$Ron at any moment in a device's life may be defined as the difference between Ron measured at that moment in the device's lifetime, and Ron of the device when pristine.

That is, considered as a function of operational time t:

$$\Delta Ron(t) = \Delta Ron(t) - \Delta Ron(0),$$

or

$$\Delta Ron(t) = \ [(Vh(t) - Vl(t)) - (Vh(0) - Vl(0)) \ ] \ / \ (ih - il).$$

As already discussed, the magnitude of Ron is a function of the chosen drive currents ih and il, and thus so is $\Delta$Ron. However, as the present inventors have made the surprising realisation and experimentally verified, $\Delta$Ron follows a linear relationship with the reduction in the normalised light output over the aging of a device, and this is to some extent independent or nearly independent of the operating conditions.

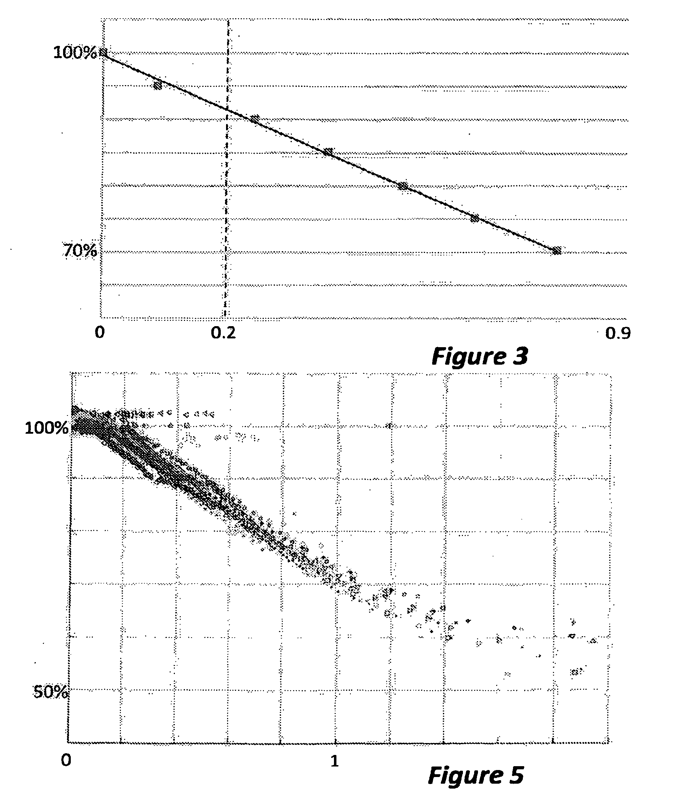

Figure 3 shows the change in $\Delta$Ron over an operational lifetime of a high-power blue LED. The figure plots, on the y-axis or ordinate, the normalised light output of the device, against on the x-axis or abscissa the increase in characteristic-resistance, that is to say ΔRon, which has the dimensions of ohms. As shown, there is a linear relationship between these two properties. Provided, then, that this relationship holds, or at least that the relationship is predictable or deterministic, by finding the ΔRon of an LED at a particular moment during its operational lifetime, it may thus be possible to deduce the relative light output of the LED at that moment, as well as to predict the remaining LED lifetime, until total failure may be expected, based on the elapsed time and past operating conditions.

As an example, consider a high-power blue LED which has been operational for an operational time t1 of 10,000 hours, and has a ΔRon of 0.2 ohm. As shown at the dashed line on the figure 3, we can calculate that the light output of this LED at t1 is 92.5% of its pristine value. From a simple linear extrapolation, since it took 10,000 hours to reduce the LED light output from a 100% to 92.5%, it will take a total of 40,000 hours to reduce it to 70%. If a light output reduction to 70% of its nominal or pristine value is taken to indicate the nominal end of the operational lifetime of the device, it can then be calculated that there is 30,000 hours remaining of the operational lifetime based on the past operation conditions.

It will be appreciated that other extrapolation algorithms for lifetime prediction, such as an exponential equation, Arrhenius equation, Black equation for meantime through the prediction, are also possible.

It will also be appreciated that, by measuring ΔRon at several moments during the operational life of the LED, a more accurate prediction of the remaining life can be achieved, and that as the device ages, the accuracy of the prediction will generally increase.

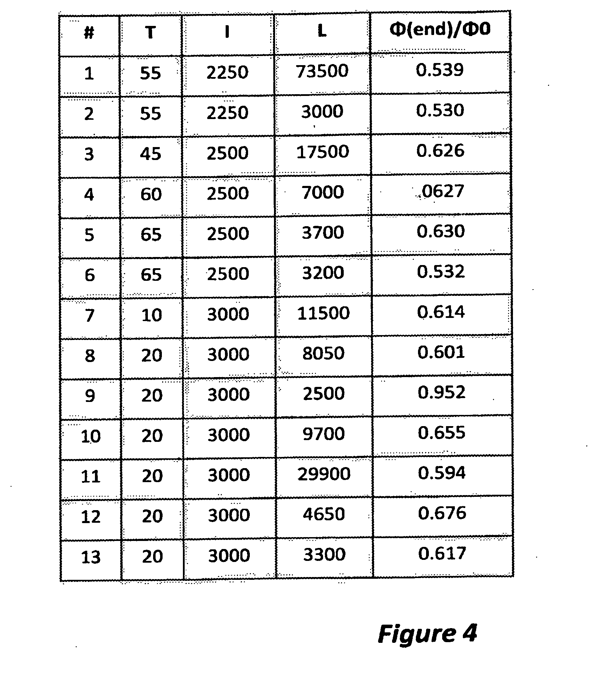

The relationship between the relative optical output and lifetime, has been experimentally verified, as shown in figure 4. Several high-power blue LEDs were tested under various conditions, and the figure shows a table, presenting, for each device (#), the test conditions being the temperature T, in °C, of the heatsink, and the current I, in mA, under which the LEDs were stressed, the total operational lifetime L, in s, of the device before total failure, and a value of $\phi(end)/\phi 0$, corresponding to the last optical output (normalised to pristine light output) just before the LED went dead, that is, at the end of its total operational lifetime, . From the figure it will be observed that the total lifetime of the devices varied, even for devices operated under the same nominal conditions, such as devices #8, #9 and #11.

Figure 5 shows the relationship between the relative light output of the devices listed in figure 4, plotted on the y-axis, and the increase in characteristic-resistance, that is to say ΔRon, plotted on the x-axis and measured in ohms. Despite the fact that the LEDs have very different total lifetimes, as demonstrated in figure 5, the relationship between each LED's Δ Ron and its relative light output follows a remarkably similar linear curve. It is thus possible to use this relationship to determine, from the measured values of ΔRon, an estimate of the relative light output. For instance, it may be predicted that if ΔRon is approximately 1 ohm, the LED is approaching the end of its economic the lifetime if the latter is defined to be 70% $\pm 3\%$ of its pristine light output.

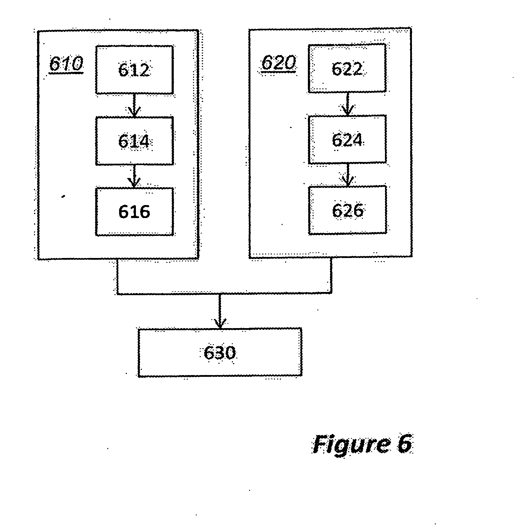

Figure 6 shows a flow diagram of a method according to embodiments.

The method includes the following steps:

- At a first known moment during the LED's operational lifetime, shown at 610, a first value of a characteristic-resistance Ron1 is determined, by determining a first and second voltage (Vh, Vl) across the LED device whilst a respective first and second current (ih, il) is passing through the device, at 612 and 614 respectively; determining, at 616, the characteristic-resistance from the ratio of the difference between the first and second voltage, and the first and second current, according to Ron = (Vh - Vl) / (ih - il);

- At a second known moment during the LED's operational lifetime shown at 620, a second value of a characteristic-resistance Ron2 is determined, by determining a first and second voltage (Vh, Vl) across the LED device whilst a respective first and second current (ih, il) is passing through the device, at 622 and 624 respectively; determining, at 626, the characteristic-resistance from the ratio of the difference between the first and second voltage, and the first and second current, according to Ron = (Vh - Vl) / (ih - il);

- Predicting an end of an operational lifetime of the device from the first value (Ron1) and second value (Ron2) of the characteristic-resistance, as shown at 630.

The skilled person will appreciate that the values of Vh and Vl at the second known moment may be different to those at the respective first known moment.

The prediction of the end of the operation lifetime of the device may be based on the difference between the values of Ron at the first and second known moments (if the first moment is at the start of the operational life, that is to say may be based upon a value of ΔRon). The first known moment may be the start of the operational life of the device: in these embodiments the difference between the values of Ron at the first and second known moments, is equal to the value of ΔRon. The prediction of the end of the operational life may be a linear extrapolation from ΔRon.

Further values of Ron may be determined at a third or subsequent known moment or moments during the LED's operational lifetime in order to improve the prediction of the operational life.

Based on the prediction of the operational life of the LED, further actions may be taken: these include providing compensation of the operating conditions of the LED, in order to either maintain the original or another predetermined optical output, or to increase be life of the LED, for instance by reducing the stress on the LED by operating it at lower power. Another action which may be taken is for instance to provide a warning related to the expected end of life.

It will be appreciated that, as used herein the term "operational life" and the like are to be construed broadly, so as to include burn-in periods or pre-screening periods. The prediction of a total operational lifetime may thus be made as a result of a pre-screening operation or a pre-stressing operation, before the LED is used in it's normal operating environment or expected application.

As has already been discussed above, the predicted total operational lifetime, and thus the predicted end of life of an LED depends on the operating conditions under which it has been operated: it will be appreciated by the skilled person that $\Delta$Ron depends on the cumulative operational flux, and the evolution of $\Delta$Ron depends on the operating conditions during that evolutionary period, rather than on the specific momentary operating conditions. Since it is not possible to know future operating conditions with certainty, the total operational lifetime prediction is subject to errors based on changes in the operating conditions. Needless to say, the accuracy will improve towards the end of lifetime, since even a significant change to the rate of deterioration then has a relatively less significant effect on the overall cumulative operating conditions.

It will be appreciated that the exact value of current chosen for either the first current or the second current is not critical. The higher current should in general be large enough to distinguish changes in contact resistance of the device. It may conveniently be chosen to be the nominal operating current of the LED itself, This may typically be between 100mA and 1A, or in general, of the order of $10^6$ $\mu$A/mm$^2$. The lower current should be chosen to adequately distinguish changes in the leakage path or paths through the device, and may be about 10$\mu$A or of the order of $10^1 \mu$A/mm$^2$, Thus the higher current may conveniently be larger than the lower current by a factor of between $10^4$ and $10^6$, and in particular by a factor of $10^5$. Since the contact resistance may be of the order of Ohms, and the leakage resistance of the order of 100kOhm, it will be appreciate that a factor of $10^5$ ratio between the currents is convenient.

Seen from one viewpoint, then, a method of characterising an LED is disclosed herein, based on a so-called characteristic resistance, in which the LED is operated at a first, relatively low, operating current and then at a second, relatively high, operating current. From the ratio between the difference between the forward voltages at these two operating currents, and the difference between the operating current, the characteristic resistance is determined. The characteristic resistance is measured at two or more moments during the operational lifetime of the device, and a prediction or estimate is made in relation to the total operational lifetime of the devices, from the evolution or change of the characteristic resistance. An integrated circuit configured to operate such a process is also disclosed.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A method of characterising an LED device, the method comprising:

   determining a first value and a second value of a characteristic-resistance Ron, by
   determining a first and second voltage (Vh, Vl) across the LED device whilst a respective first and second current (ih, il) is passing through the device;
   determining the characteristic-resistance from the ratio of the difference between the first and second voltage, and the first and second current,
   according to

   $$Ron = (Vh - Vl) / (ih - il);$$

   and predicting an end of an operational lifetime of the device from the first value (Ron1) and second value (Ron2) of the characteristic-resistance.

2. The method of claim 1, wherein the first value of the characteristic-resistance is determined at the start of an operational lifetime of the LED device.

3. The method of claim 1, wherein the second value of the characteristic-resistance is determined after a part of an operational lifetime of the LED device.

4. The method of claim 2, wherein the first value of the characteristic-resistance is determined after a further part of the operational lifetime of the LED device, and further comprising extrapolating to estimate a value of the characteristic-resistance at a start of the operational lifetime of the LED device.

5. The method of any preceding claim, further comprising determining at least one further value of the characteristic resistance after respectively at least one further part of the operational lifetime, and wherein predicting an end of an operational lifetime comprises extrapolating an evolution of the characteristic resistance against operational lifetime.

6. The method of any preceding claim, further comprising storing at least a value of the characteristic resistance in a memory.

7. The method of any preceding claim, wherein the end of an operational lifetime is predicted to be when the characteristic-resistance Ron differs from its value at the start of the operational lifetime, by a predetermined amount.

8. The method of any preceding claim, wherein the first current is larger than the second current by between 4 and 6 orders of magnitude.

9. The method of claim 7, wherein the first current is larger than the second current by 5 orders of magnitude.

10. The method of any preceding claim, further comprising providing a warning signal indicative of the predicted end of an operational lifetime.

11. The method of any of claims 1 to 8, wherein the method further comprises selecting one of a plurality of performance bins based on the predicted end of an operational lifetime.

12. An integrated circuit configured to drive an LED device and to operate the method of any preceding claim.

**Patentansprüche**

1. Ein Verfahren zum Charakterisieren einer LED Vorrichtung, wobei das Verfahren aufweist:

Bestimmen eines ersten Werts und eines zweiten Werts eines Charakteristik-Widerstands Ron, mittels Bestimmens einer ersten und einer zweiten Spannung (Vh, Vl) über der LED Vorrichtung, während jeweils ein erster und ein zweiter Strom (ih, il) durch die Vorrichtung fließt; Bestimmens des Charakteristik-Widerstands aus dem Verhältnis der Differenz zwischen der ersten und der zweiten Spannung, und dem ersten und dem zweiten Strom, gemäß

$$\text{Ron} = (Vh - Vl) / (ih - il);$$

und Prognostizieren eines Endes einer funktionsfähigen Lebensdauer der Vorrichtung aus dem ersten Wert (Ron1) und dem zweiten Wert (Ron2) des Charakteristik-Widerstands.

2. Das Verfahren gemäß Anspruch 1, wobei der erste Wert des Charakteristik-Widerstands zu Beginn einer funktionsfähigen Lebensdauer der LED Vorrichtung bestimmt wird.

3. Das Verfahren gemäß Anspruch 1, wobei der zweite Wert des Charakteristik-Widerstands nach einem Teil einer funktionsfähigen Lebensdauer der LED Vorrichtung bestimmt wird.

4. Das Verfahren gemäß Anspruch 2, wobei der erste Wert des Charakteristik-Widerstands nach einem weiteren Teil der funktionsfähigen Lebensdauer der LED Vorrichtung bestimmt wird, und ferner aufweisend Extrapolieren, um einen Wert des Charakteristik-Widerstands zu einem Beginn der funktionsfähigen Lebensdauer der LED Vorrichtung zu schätzen.

**5.** Das Verfahren gemäß irgendeinem vorangehenden Anspruch, ferner aufweisend Bestimmen von zumindest einem weiteren Wert des Charakteristik-Widerstands nach jeweils zumindest einem weiteren Teil der funktionsfähigen Lebensdauer, und wobei Prognostizieren eines Endes einer funktionsfähigen Lebensdauer aufweist Extrapolieren einer Entwicklung des Charakteristik-Widerstands gegen die funktionsfähige Lebensdauer.

**6.** Das Verfahren gemäß irgendeinem vorangehenden Anspruch, ferner aufweisend Speichern von zumindest einem Wert des Charakteristik-Widerstands in einem Speicher.

**7.** Das Verfahren gemäß irgendeinem vorangehenden Anspruch, wobei das Ende einer funktionsfähigen Lebensdauer prognostiziert wird zu sein, wenn der Charakteristik-Widerstand Ron sich um einen vorbestimmten Betrag von seinem Wert zu Beginn der funktionsfähigen Lebensdauer unterscheidet.

**8.** Das Verfahren gemäß irgendeinem vorangehenden Anspruch, wobei der erste Strom um zwischen 4 und 6 Größenordnungen stärker ist als der zweite Strom.

**9.** Das Verfahren gemäß Anspruch 7, wobei der erste Strom um 5 Größenordnungen stärker ist als der zweite Strom.

**10.** Das Verfahren gemäß irgendeinem vorangehenden Anspruch, ferner aufweisend Bereitstellen eines Warnsignals, welches für das prognostizierte Ende einer funktionsfähigen Lebensdauer indikativ ist.

**11.** Das Verfahren gemäß irgendeinem der Ansprüche 1 bis 8, wobei das Verfahren ferner aufweist Auswählen von einem von einer Mehrzahl von Performance Bins, basierend auf dem prognostizierten Ende der funktionsfähigen Lebensdauer.

**12.** Ein integrierter Schaltkreis, welcher konfiguriert ist, eine LED Vorrichtung anzutreiben und das Verfahren gemäß irgendeinem vorangehenden Anspruch durchzuführen.

**Revendications**

**1.** Procédé de caractérisation d'un dispositif à DEL, le procédé comprenant :

la détermination d'une première valeur et d'une deuxième valeur d'une résistance caractéristique Ron par détermination d'une première et d'une deuxième tension (Vh, Vl) aux bornes du dispositif à DEL simultanément au passage d'un premier et d'un deuxième courant respectif (ih, il) dans le dispositif ;
détermination de la résistance caractéristique à partir du rapport de la différence entre la première et la deuxième tension sur la différence entre le premier et le deuxième courant, conformément à

$$Ron = (Vh - Vl)/(ih - il) ;$$

et la prédiction d'une fin d'une durée de vie en service du dispositif à partir de la première valeur (Ron1) et de la deuxième valeur (Ron2) de la résistance caractéristique.

**2.** Procédé selon la revendication 1, dans lequel la première valeur de la résistance caractéristique est déterminée au début d'une durée de vie en service du dispositif à DEL.

**3.** Procédé selon la revendication 1, dans lequel la deuxième valeur de la résistance caractéristique est déterminée après une partie d'une durée de vie en service du dispositif à DEL.

**4.** Procédé selon la revendication 2, dans lequel la première valeur de la résistance caractéristique est déterminée après une partie supplémentaire de la durée de vie en service du dispositif à DEL, et comprenant en outre une extrapolation visant à estimer une valeur de la résistance caractéristique à un début de la durée de vie en service du dispositif à DEL.

**5.** Procédé selon l'une quelconque des revendications précédentes, comprenant en outre la détermination d'au moins une valeur supplémentaire de la résistance caractéristique après respectivement au moins une partie supplémentaire de la durée de vie en service, et dans lequel la prédiction d'une fin d'une durée de vie en service comprend l'extrapolation d'une évolution de la résistance caractéristique en fonction de la durée de vie en service.

**6.** Procédé selon l'une quelconque des revendications précédentes, comprenant en outre l'enregistrement d'au moins une valeur de la résistance caractéristique dans une mémoire.

**7.** Procédé selon l'une quelconque des revendications précédentes, dans lequel la fin d'une durée de vie en service est prédite comme étant survenue si la résistance caractéristique Ron diffère de sa valeur au début de la durée de vie en service d'une quantité prédéfinie.

**8.** Procédé selon l'une quelconque des revendications précédentes, dans lequel le premier courant est supérieur d'entre 4 et 6 ordres de grandeur au deuxième courant.

**9.** Procédé selon la revendication 7, dans lequel le premier courant est supérieur de 5 ordres de grandeur au deuxième courant.

**10.** Procédé selon l'une quelconque des revendications précédentes, comprenant en outre la production d'un signal d'avertissement indiquant la fin prédite d'une durée de vie en service.

**11.** Procédé selon l'une quelconque des revendications 1 à 8, comprenant en outre la sélection d'un parmi une pluralité de compartiments de performances sur la base de la fin prédite d'une durée de vie en service.

**12.** Circuit intégré configuré pour attaquer un dispositif à DEL et pour mettre en oeuvre le procédé selon l'une quelconque des revendications précédentes.

Figure 1

Figure 2(a)

LED effective resistance at 10μA drive current

Figure 2(b)

*Figure 3*

*Figure 5*

| # | T | I | L | Φ(end)/Φ0 |
|---|---|---|---|---|
| 1 | 55 | 2250 | 73500 | 0.539 |
| 2 | 55 | 2250 | 3000 | 0.530 |
| 3 | 45 | 2500 | 17500 | 0.626 |
| 4 | 60 | 2500 | 7000 | .0627 |
| 5 | 65 | 2500 | 3700 | 0.630 |
| 6 | 65 | 2500 | 3200 | 0.532 |
| 7 | 10 | 3000 | 11500 | 0.614 |
| 8 | 20 | 3000 | 8050 | 0.601 |
| 9 | 20 | 3000 | 2500 | 0.952 |
| 10 | 20 | 3000 | 9700 | 0.655 |
| 11 | 20 | 3000 | 29900 | 0.594 |
| 12 | 20 | 3000 | 4650 | 0.676 |
| 13 | 20 | 3000 | 3300 | 0.617 |

*Figure 4*

*Figure 6*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100327872 A
- US 20070205793 A
- US 20070040696 A